# EUROPÄISCHE PATENTSCHRIFT

(11) **EP 3 189 271 B1**
(45) Veröffentlichungstag und Bekanntmachung des Hinweises auf die Patenterteilung: **28.11.2018**
(21) Anmeldenummer: 15760409.1
(22) Anmeldetag: 26.08.2015
(51) Int. Cl.: F21V 9/30

(54) **BELEUCHTUNGSVORRICHTUNG ZUR VARIABLEN BELEUCHTUNG**
ILLUMINATION DEVICE FOR VARIABLE ILLUMINATION
DISPOSITIF D'ÉCLAIRAGE POUR ÉCLAIRAGE VARIABLE

(30) Priorität: 02.09.2014 DE 102014217521
(43) Veröffentlichungstag der Anmeldung: 12.07.2017
(73) Patentinhaber: OSRAM GmbH, 80807 München (DE)
(72) Erfinder: REHN, Henning, 13407 Berlin (DE); KHRUSHCHEV, Sergey, 93049 Regensburg (DE)
(86) Internationale Anmeldenummer: PCT/EP2015/069482
(87) Internationale Veröffentlichungsnummer: WO 2016/034460

(56) Entgegenhaltungen:
- WO-A1-2012/025141

## Beschreibung

### Technisches Gebiet

Die vorliegende Erfindung betrifft eine Beleuchtungsvorrichtung mit einer Pumpstrahlungseinheit zur Emission von Pumpstrahlung und einem Leuchtstoffelement zur zumindest teilweisen Konversion der Pumpstrahlung.

### Stand der Technik

Als Lichtquellen hoher Leuchtdichte sind gegenwärtig Gasentladungslampen noch am weitesten verbreitet. Jüngere Entwicklungen gehen jedoch dahin, eine Pumpstrahlungsquelle hoher Leistungsdichte, beispielsweise einen Laser, mit einem dazu beabstandet angeordneten Leuchtstoffelement zu kombinieren. Das Leuchtstoffelement konvertiert die Pumpstrahlung zumindest teilweise, emittiert auf die Anregung hin also Konversionsstrahlung, nämlich Beleuchtungslicht, das zumindest Anteile im sichtbaren Spektralbereich hat.

Der vorliegenden Erfindung liegt das technische Problem zugrunde, eine vorteilhafte Beleuchtungsvorrichtung mit Pumpstrahlungseinheit und Leuchtstoffelement anzugeben. WO 2012/025.141 offenbart eine Beleuchtungsvorrichtung gemäß dem Oberbegriff des Anspruchs 1.

### Darstellung der Erfindung

Erfindungsgemäß löst diese Aufgabe eine Beleuchtungsvorrichtung gemäß Anspruch 1.

Bevorzugte Ausführungsformen finden sich in den abhängigen Ansprüchen und der nachstehenden Beschreibung, wobei in der Darstellung nicht immer im Einzelnen zwischen Vorrichtungs- und Verwendungsaspekten unterschieden wird; jedenfalls implizit ist die Offenbarung hinsichtlich sämtlicher Anspruchskategorien zu lesen.

Die Optik wird also zweifach genutzt, nämlich um einerseits das Beleuchtungslicht von der Beleuchtungslicht-Abstrahlfläche (BL-Abstrahlfläche) wegzuführen, und andererseits aber auch, um die Pumpstrahlung dorthin zu führen. So wie einerseits die an unterschiedlichen Stellen der BL-Abstrahlfläche abgegebenen Beleuchtungslicht-Strahlenbündel (BL-Strahlenbündel) von der Optik in jeweils eine andere Raumrichtung gelenkt werden, lenkt die Optik andererseits die aus unterschiedlichen Raumrichtungen einfallenden Pumpstrahlenbündel auf unterschiedliche Stellen der BL-Abstrahlfläche.

Mit der Optik wird im Falle des Beleuchtungslichts die Ortsverteilung auf der BL-Abstrahlfläche in eine beleuchtungsseitige Winkelverteilung umgesetzt und im Falle der Pumpstrahlenbündel eine beleuchtungsseitige Winkelverteilung in eine Ortsverteilung auf der BL-Abstrahlfläche. Die BL-Abstrahlfläche ist also zugleich Pumpstrahlungs-Einstrahlfläche (wird jedoch im Folgenden weiterhin nur als BL-Abstrahlfläche bezeichnet). An der entgegengesetzten Rückseite des Leuchtstoffelements kann vorzugsweise ein Kühlkörper angeordnet werden, etwa auch aus Metall. Durch die ortsabhängige Anregung der BL-Abstrahlfläche erfolgt entsprechend auch die Emission des Beleuchtungslichts ortsabhängig und damit in die gewünschten Raumrichtungen.

Mit der Pumpstrahlungseinheit können die Pumpstrahlenbündel einstellbar in unterschiedliche Raumrichtungen abgegeben werden, sodass sie dementsprechend einstellbar aus den unterschiedlichen Raumrichtungen kommend auf die Beleuchtungsseite der Optik treffen; von dieser werden sie dann auf die unterschiedlichen Stellen der BL-Abstrahlfläche gelenkt. Entsprechend können einstellbar Anregungs- und damit Emissionsmuster auf der BL-Abstrahlfläche erzeugt werden.

Wird also beispielsweise nur ein Teilbereich der BL-Abstrahlfläche mit Pumpstrahlung angeregt, wird auch nur in diesem Teilbereich Beleuchtungslicht emittiert. Entsprechend wird dann nur in die beleuchtungsseitig dem Teilbereich korrespondierenden Raumrichtungen Beleuchtungslicht abgegeben; es bleibt ein Raumwinkelbereich dunkel, der einem zu dem Teilbereich komplementären Restbereich der BL-Abstrahlfläche entspricht.

Die "Leuchtstoffseite" der Optik ist dem Leuchtstoffelement zugewandt, nämlich dessen BL-Abstrahlfläche; an der Leuchtstoffseite tritt das an der BL-Abstrahlfläche abgegebene Beleuchtungslicht in die Optik ein, jedenfalls ein Teil davon, etwa mindestens 25 %, vorzugsweise mindestens 50 %, besonders bevorzugt mindestens 75 %. Das Beleuchtungslicht durchsetzt die Optik und tritt dann an der entgegengesetzten "Beleuchtungsseite" aus.

Das "Leuchtstoffelement" muss im Allgemeinen nicht statisch sein, sondern es kann sich beispielsweise auch um ein rotierendes Leuchtstoffelement, etwa ein Leuchtstoffrad oder eine Leuchtstoffwalze, handeln; bevorzugt ist jedoch ein statisches Leuchtstoffelement, das also relativ zu der Optik orts- und orientierungsfest vorgesehen ist. Im Allgemeinen könnte die Pumpstrahlung auch in kürzerwelliges Beleuchtungslicht konvertiert werden (*up-conversion*), bevorzugt ist jedoch eine *downconversion,* ist das Beleuchtungslicht also längerwellig im Vergleich zur Pumpstrahlung. Die Pumpstrahlung kann beispielsweise im ultravioletten oder blauen Spektralbereich liegen.

Im Allgemeinen kann "einstellbare Abgabe" (eines jeweiligen Pumpstrahlenbündels) beispielsweise auch meinen, dass im Betrieb der Beleuchtungsvorrichtung die Intensität eines jeweiligen Pumpstrahlenbündels zwar verändert, aber nicht gleich Null wird. Die Pumpstrahlungseinheit soll eine "Richtungskompetenz" haben, sodass die Intensität der aus unterschiedlichen Raumrichtungen auf die Beleuchtungsseite fallenden Pumpstrahlenbündel je Pumpstrahlenbündel und damit je Raumrichtung einstellbar ist. Aufgrund der Winkel-/Orts-Transformation durch die Optik sind so also die unterschiedlichen Stellen der BL-Abstrahlfläche jeweils für sich einstellbar mit Pumpstrahlung versorgbar.

Vorzugsweise können die Pumpstrahlenbündel zu- und vollständig weggeschaltet (I = 0) werden. Insoweit meint "einstellbar" dann zu- und wegschaltbar, und zwar während des Betriebs der Beleuchtungsvorrichtung. Das Wegschalten kann vorzugsweise durch Ausschalten der Pumpstrahlungsquelle selbst erfolgen, im Allgemeinen aber beispielsweise auch durch ein Auslenken des entsprechenden Pumpstrahlenbündels derart, dass es nicht auf die BL-Abstrahlfläche fällt.

Die "Raumrichtung" eines Strahlenbündels ergibt sich als Mittelwert sämtlicher Richtungsvektoren dieses Strahlenbündels, wobei bei dieser Mittelwertbildung jeder Richtungsvektor mit der ihm zugehörigen Strahlstärke gewichtet wird. Vorzugsweise sind die in Rede stehenden Strahlenbündel (sowohl Pumpstrahlenbündel als auch BL-Strahlenbündel) in dem in Rede stehenden Bereich, also beleuchtungsseitig, jeweils für sich kollimiert. Die Raumrichtung eines solchen Strahlenbündels entspricht dann der Richtung seiner zueinander parallelen Strahlen; andererseits ist ein "Strahlenbündel" dann die Gesamtheit der beleuchtungsseitig zueinander parallelen Strahlen.

In bevorzugter Ausgestaltung ist die Optik also leuchtstoffseitig telezentrisch; es werden die von den unterschiedlichen Stellen der Beleuchtungslicht-Abstrahlfläche ausgehenden BL-Strahlenbündel jeweils für sich kollimiert in die unterschiedlichen Raumrichtungen gelenkt. So lassen sich auch in einem vergleichsweise großen Abstand, etwa von mehreren 10 oder sogar mehreren 100 Metern, klar definierte Beleuchtungslichtverteilungen erzeugen. Es kann beispielsweise definiert eine Fahrbahn ausgeleuchtet werden; ein bevorzugtes Anwendungsgebiet sind Kfz-Scheinwerfer.

Weiter bevorzugt werden im Falle der jeweils für sich kollimierten BL-Strahlenbündel dann auch die Pumpstrahlenbündel jeweils für sich kollimiert eingekoppelt. Die Pumpstrahlenbündel fallen dann also als jeweils für sich parallele, zueinander jedoch in den Raumrichtungen verkippte Strahlenbündel auf die Beleuchtungsseite der Optik, durchsetzen diese und treffen jeweils fokussiert auf die BL-Abstrahlfläche. Die Kollimation ist auf der Beleuchtungsseite der Optik, dieser hinsichtlich der Pumpstrahlungsausbreitung unmittelbar vorgelagert gegeben; die Optik bündelt die Pumpstrahlenbündel jeweils für sich, nämlich invers zu den BL-Strahlenbündeln (die in entgegengesetzter Richtung von der Optik jeweils für sich kollimiert werden).

Ein Vorteil dieser Ausführungsform kann beispielsweise darin bestehen, dass dann bei der Einkopplung der Pumpstrahlenbündel lediglich die abzudeckenden Raumrichtungen berücksichtigt werden müssen, im Übrigen aber die Optik sicherstellt, dass jedes Pumpstrahlenbündel für sich fokussiert auf die BL-Abstrahlfläche fällt. Um beleuchtungsseitig ein kollimiertes BL-Strahlenbündel zu erhalten, das sich in einer bestimmten Raumrichtung ausbreitet, wird ein Pumpstrahlenbündel in der zu dieser Raumrichtung genau entgegengesetzten Raumrichtung auf die Beleuchtungsseite der Optik gelenkt.

In bevorzugter Ausgestaltung ist die Optik ein ausschließlich refraktives Linsensystem, das also die Strahlenbündel allein durch Lichtbrechung formt. Im Allgemeinen wäre beispielsweise auch eine Optik mit einem reflektiven Element denkbar, etwa auch einer Totalreflexionslinse. Wenngleich das bevorzugte, ausschließlich refraktive Linsensystem generell auch asphärische Linsen aufweisen kann, deren Freiformflächen beispielsweise simulatorisch hinsichtlich der gewünschten Strahlformung optimiert sind, ist ein ausschließlich aus sphärischen Linsen aufgebautes Linsensystem bevorzugt.

Dieses Linsensystem kann dann beispielsweise aus mindestens drei, vorzugsweise mindestens vier, weiter bevorzugt mindestens fünf, sphärischen Linsen (Einzellinsen) bestehen, vgl. die Ausführungsbeispiele zur Illustration. Mit einer größeren Anzahl an sphärischen Linsen bzw. mit asphärischen Linsen kann sich die Effizienz erhöhen lassen, können also BL-Strahlenbündel mit größeren Öffnungswinkeln kollimiert, kann also mehr Beleuchtungslicht aufgesammelt werden; die Emission an der BL-Abstrahlfläche erfolgt nämlich typischerweise Lambertsch.

Gemäß der Erfindung weist die Pumpstrahlungseinheit einen Einkoppelspiegel auf, über welchen die Pumpstrahlenbündel auf die Optik, also auf deren Beleuchtungsseite, gelenkt werden. Von dem Einkoppelspiegel weg haben die Pumpstrahlenbündel dann die jeweilige Raumrichtung, mit welcher sie auf die Optik treffen. Der Einkoppelspiegel ist im Strahlengang der BL-Strahlenbündel angeordnet, und zwar vorzugsweise dort, wo die BL-Strahlenbündel jeweils für sich kollimiert sind. Dort ist der Öffnungswinkel eines jeden BL-Strahlenbündels im Wesentlichen gleich Null (im Rahmen des technisch Üblichen), also jedenfalls sehr klein, weswegen (aufgrund der Etendue-Erhaltung) umgekehrt der senkrecht zur Ausbreitungsrichtung genommene Strahlquerschnitt maximal ist. Deshalb kann selbst ein für das Beleuchtungslicht reflektiver Spiegel ("Vollspiegel") im Strahlengang angeordnet werden, der dann zwar aus jedem BL-Strahlenbündel einen kleinen Bereich ausschneidet; der Spiegel und damit der abgeschattete Bereich kann jedoch im Verhältnis zum Strahlquerschnitt klein gehalten werden.

Auch deshalb sind Pumpstrahlenbündel hoher Leistungsdichte bevorzugt; die Pumpstrahlenbündel (bzw. ein diesen zugrundeliegendes Primärstrahlenbündel, siehe unten) können vorzugsweise verdichtet werden, etwa mit einem Treppenspiegel oder einem Teleskop. Es wird also die Leistungsdichte des Primärstrahlenbündels / der Pumpstrahlenbündel erhöht.

Von einem BL-Strahlenbündel, vorzugsweise von einem jeden BL-Strahlenbündel, soll der Einkoppelspiegel beispielsweise nicht mehr als 30 %, vorzugsweise nicht mehr als 20 %, weiter bevorzugt nicht mehr als 10 %, abschatten. Dies meint, dass für ein jeweiliges BL-Strahlenbündel eine senkrechte Projektion des Einkoppelspiegels in eine zur BL-Strahlenbündelrichtung senkrechte Ebene nicht mehr als einen entsprechenden Prozentsatz des Strahlquerschnitts (des jeweiligen BL-Strahlenbündels) in der entsprechenden Ebene bedeckt.

Im Allgemeinen kann der Einkoppelspiegel beispielsweise auch dichroitisch sein, also das Pumplicht reflektieren, das Beleuchtungslicht jedoch transmittieren (jeweils zumindest zum größeren Teil, also beispielsweise zu mindestens 60 % 70 % bzw. 80 %). Die Anordnung im Bereich der jeweils für sich kollimierten BL-Strahlenbündel kann dann beispielsweise auch insoweit einen Vorteil bieten, als die Streuung der Einfallswinkel dort minimiert sein kann (und die Transmissions-/Reflexionseigenschaften auch vom Einfallswinkel abhängen). Vorzugsweise ist als Einkoppelspiegel jedoch ein Vollspiegel vorgesehen, was beispielsweise hinsichtlich der Robustheit und Kosten Vorteile bieten kann.

Gemäß der Erfindung weist die Pumpstrahlungseinheit einen Auslenkspiegel auf, auf den ein von der Pumpstrahlungsquelle emittiertes Primärstrahlenbündel fällt und in Abhängigkeit von einer Spiegelstellung (des Auslenkspiegels) davon als zumindest eines der Pumpstrahlenbündel umgelenkt wird. Im Allgemeinen könnte beispielsweise auch ein einstellbares Beugungsgitter zur Auslenkung der Pumpstrahlenbündel in unterschiedliche Raumrichtungen vorgesehen sein oder auch die Pumpstrahlungsquelle selbst bewegt werden.

Der bevorzugte Auslenkspiegel kann beispielsweise als Mikroscanner vorgesehen sein, der in zumindest einer Achse, vorzugsweise in zwei bevorzugt zueinander senkrechten Achsen, verkippbar ist. Fällt auf den Mikroscanner dann ein Primärstrahlenbündel, wird es in Abhängigkeit von der Spiegelstellung als eines der Pumpstrahlenbündel umgelenkt; bei einer anderen Spiegelstellung ergibt sich entsprechend ein anderes Pumpstrahlenbündel (das sich vom vorherigen in seiner Richtung unterscheidet). Bei einer Bewegung des Spiegels kann es insoweit beliebig viele Pumpstrahlenbündel geben; fällt ein Primärstrahlenbündel ein, gibt es je Spiegelstellung ein "Pumpstrahlenbündel".

Im zeitlichen Verlauf können die Pumpstrahlenbündel die BL-Abstrahlfläche dann beispielsweise zeilen- und/oder spaltenförmig anregen. In Abhängigkeit von der gewünschten Lichtverteilung im Fernfeld kann die Leistung der Pumpstrahlungsquelle mit dem Mikroscanner getaktet erhöht und verringert werden bzw. kann die Pumpstrahlungsquelle damit getaktet ein- und ausgeschaltet werden. Bei dem Microscanner handelt es sich um ein opto-elektro-mechanisches System (MOEMS), also um einen Mikrospiegelaktor.

Bei dem Microscanner liegen die Pumpstrahlenbündel sequenziell vor, jedenfalls soweit sie auf dasselbe Primärstrahlenbündel zurückgehen; im Falle mehrerer Pumpstrahlungsquellen und damit mehrerer Primärstrahlenbündel können auch mehrere Pumpstrahlenbündel gleichzeitig vorliegen.

In einer nicht beanspruchten Ausführungsform kann der Auslenkspiegel auch zugleich Einkoppelspiegel sein, also im Strahlengang der BL-Strahlenbündel angeordnet werden. Gemäß der Erfindung handelt es sich dabei jedoch um zwei separate Spiegel und ist der Einkoppelspiegel dem Auslenkspiegel nachgelagert als orts- und orientierungsfestes Teil im Strahlengang der BL-Strahlenbündel angeordnet. Der Einkoppelspiegel soll also in seiner Relativposition zu der Optik festgelegt sein und auch nicht verdreh-/verkippbar sein. Dies ist insoweit vorteilhaft, als dann eine Halterung entsprechend einfach ausgeführt sein kann und damit eine geringe Abschattung erzeugt.

Der dem Einkoppelspiegel hinsichtlich der Pumpstrahlungsausbreitung vorgelagerte Auslenkspiegel ist außerhalb des Strahlengangs der BL-Strahlenbündel angeordnet, sodass beispielsweise auch ein standardmäßig gehäustes Bauteil mit im Verhältnis zur Bauteilgröße kleiner Spiegelfläche eingesetzt werden kann. Dies kann beispielsweise Kostenvorteile bieten, insbesondere in einer Massenfertigung.

Gemäß der Erfindung ist zwischen dem Einkoppelspiegel und dem hinsichtlich der Pumpstrahlungsausbreitung vorgelagerten Auslenkspiegel ein Relay-Linsensystem vorgesehen ("zwischen" bezogen auf den Pfad der Pumpstrahlung). Dieses verlängert den optischen Pfad, was beispielsweise hinsichtlich des bevorzugten Anwendungsgebiets "Automobilscheinwerfer" von Interesse sein kann; die Pumpstrahlungsquelle kann dann nämlich ein Stück weit beabstandet zu der Optik-/Leuchtstoffelement-Einheit angeordnet werden, die beispielsweise aus Designgründen besonderen Platzbeschränkungen unterliegen kann.

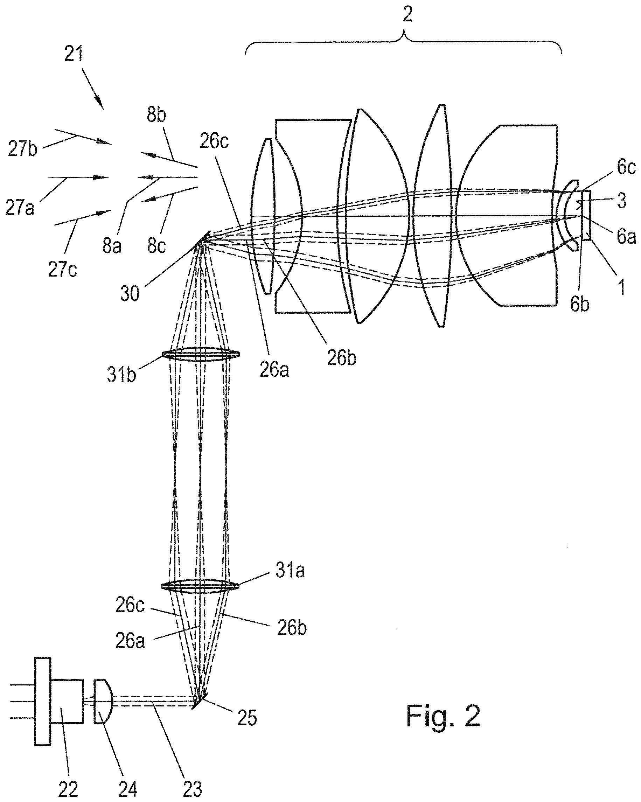

Das Relay-Linsensystem bildet den Auslenkspiegel auf den Einkoppelspiegel ab; infolgedessen werden Pumpstrahlenbündel, die den Auslenkspiegel in unterschiedlichen Richtungen verlassen, auf dem Einkoppelspiegel wieder zusammengeführt, siehe beispielsweise Fig. 2 zur Illustration. In den Figuren ist der Abbildungsmaßstab M = 1:1 (Bild/Gegenstand), jedoch kann auch ein anderer Maßstab von Interesse sein. Vorteilhafte Untergrenzen können beispielsweise bei 1:10, 1:5 bzw. 1:2 liegen, vorteilhafte Obergrenzen etwa bei 10:1, 5:1 bzw. 2:1, jeweils in der Reihenfolge der Nennung zunehmend bevorzugt (Ober- und Untergrenze können auch unabhängig voneinander von Interesse sein).

Wenngleich im Allgemeinen auch eine einzige Linse als Relay-Linsensystem vorgesehen sein könnte, ist ein System aus mindestens zwei Linsen bevorzugt; die Zahl der Linsen des Relay-Linsensystems kann beispielsweise bei 2n liegen, mit n = 1, 2, 3, 4 oder 5 (auch höhere Werte sind im Allgemeinen möglich).

In bevorzugter Ausgestaltung ist der Einkoppelspiegel im leuchtstoffseitigen Brennpunkt der Ausgangslinse des Relay-Linsensystems angeordnet, also der hinsichtlich der Pumpstrahlungsausbreitung letzten Linse des Systems. Dieser vorgelagert sind die Pumpstrahlenbündel dann relativ zueinander kollimiert, sodass sie relativ zueinander gebündelt auf den Einkoppelspiegel fallen. Die Ausgangslinse (und damit auch das übrige Relay-Linsensystem) ist vorzugsweise außerhalb des Strahlengangs der BL-Strahlenbündel angeordnet. Jeweils für sich ist jedes der Pumpstrahlenbündel der Ausgangslinse vorgelagert vorzugsweise divergent, sodass jedes Pumpstrahlenbündel für sich von der Ausgangslinse kollimiert wird.

In bevorzugter Ausgestaltung ist der Auslenkspiegel im pumpstrahlungsquellenseitigen Brennpunkt der Eingangslinse des Relay-Linsensystems angeordnet, also der hinsichtlich der Pumpstrahlungsausbreitung ersten Linse des Systems. Vom Auslenkspiegel relativ zueinander divergent ausgehende Pumpstrahlenbündel werden dann von der Eingangslinse relativ zueinander kollimiert und können dann beispielsweise im Falle eines Systems aus zwei Linsen so auf die Ausgangslinse fallen (siehe oben). Vorzugsweise sind die Pumpstrahlenbündel der Eingangslinse vorgelagert jeweils für sich kollimiert, wird also jedes Pumpstrahlenbündel für sich von der Eingangslinse fokussiert (und dann von der Ausgangslinse wieder kollimiert, siehe oben).

Im besonders bevorzugten Fall des aus zwei Linsen, nämlich Eingangs- und Ausgangslinse, bestehenden Relay-Linsensystems sind diese beiden bevorzugt derart angeordnet, dass der leuchtstoffseitige Brennpunkt der Eingangslinse mit dem pumpstrahlungsquellenseitigen Brennpunkt der Ausgangslinse zusammenfällt. Vorzugsweise sind die Eingangs- und die Ausgangslinse jeweils für sich symmetrisch und haben sie dieselben Brennweite.

Bei einer bevorzugten Ausführungsform können auch mehrere Pumpstrahlungseinheiten vorgesehen sein, beispielsweise mindestens 2, 3, 4 bzw. 5 Pumpstrahlungseinheiten; mögliche Obergrenzen liegen beispielsweise bei höchstens 15, 10 bzw. 8 Pumpstrahlungseinheiten. Die Pumpstrahlungseinheiten können sich beispielsweise auch in ihrer Wellenlänge unterscheiden, es kann also mit Pumpstrahlung unterschiedlicher Wellenlänge angeregt werden. Die Pumpstrahlungseinheiten können sich z. B. in ihrer dominanten Wellenlänge unterscheiden; eine Pumpstrahlungseinheit kann beispielsweise auf eine gute Farbwiedergabe/Farbtemperatur hin und die andere auf eine gute Effizienz/Lebensdauer hin optimiert sein.

Auch im Falle mehrerer Pumpstrahlungseinheiten kann im Allgemeinen mit jeder davon die gesamte BL-Abstrahlfläche angeregt werden; vorzugsweise ist die BL-Abstrahlfläche dann jedoch in Teilbereiche untergliedert, wobei jedem davon eine Pumpstrahlungsquelle zugeordnet ist (die Teilbereiche sollen dann zumindest teilweise nicht überlappen).

Jede Pumpstrahlungseinheit weist eine eigene Pumpstrahlungsquelle auf; vorzugsweise teilen sich eine Mehrzahl Pumpstrahlungseinheiten jedoch einen gemeinsamen Einkoppelspiegel. Generell können dabei auch mehrere Einkoppelspiegel vorgesehen sein, denen jeweils mehrere Pumpstrahlungsquellen zugeordnet sind. Die Mehrzahl Pumpstrahlungsquellen können beispielsweise auch umlaufend verteilt angeordnet sein (hinsichtlich eines Umlaufs um die optische Achse der Optik), was beispielsweise bei einer Projektionsanwendung, etwa im Bereich der digitalen Kinoprojektion, von Interesse sein kann.

Vorzugsweise ist genau ein Einkoppelspiegel vorgesehen und sind diesem mehrere Pumpstrahlungsquellen zugeordnet, was hinsichtlich einer Minimierung der Abschattung von Vorteil sein kann.

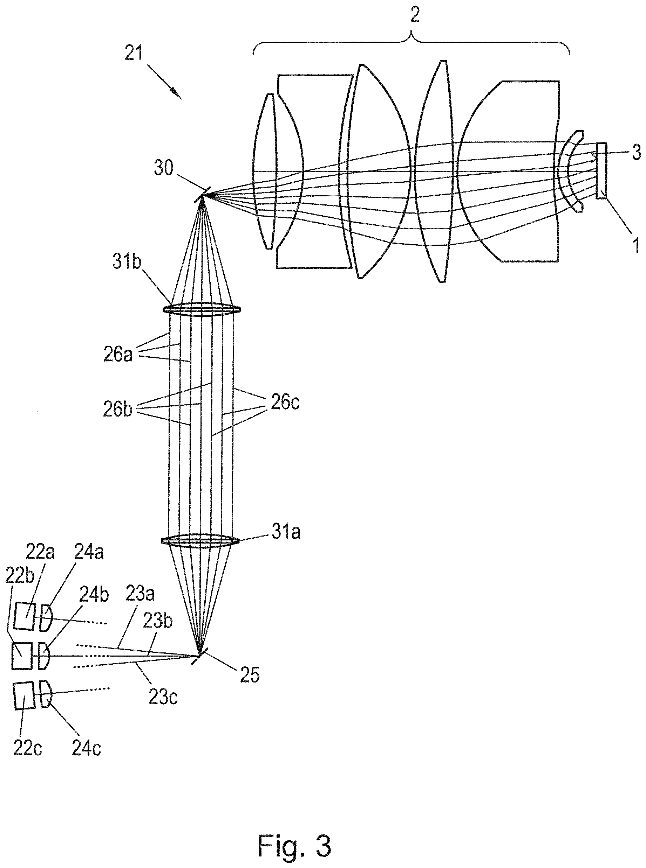

Zusätzlich zu dem Einkoppelspiegel können sich mehrere Pumpstrahlungsquellen beispielsweise auch einen Auslenkspiegel und, soweit vorhanden, ein Relay-Linsensystem als weiteres/weitere gemeinsame(s) Element(e) teilen, vgl. Fig. 3 zur Illustration. Auch im Falle eines Mikroscanners als Auslenkspiegel können dann mehrere Pumpstrahlenbündel gleichzeitig auf die BL-Abstrahlfläche fallen, nämlich der Anzahl der Pumpstrahlungsquellen entsprechend viele Pumpstrahlenbündel; diese können dann beispielsweise individuell zu- und weggeschaltet werden.

Die vorliegende Erfindung betrifft auch einen Kfz-Scheinwerfer mit einer vorliegend offenbarten Beleuchtungsvorrichtung, vorzugsweise einen Kfz-Frontscheinwerfer. Der Kfz-Scheinwerfer kann beispielsweise auch eine Steuer- und/oder Erfassungseinheit aufweisen. Als Erfassungseinheit kann etwa eine Kamera vorgesehen sein, welche den beleuchtungsseitig mit den BL-Strahlenbündeln zugänglichen Bereich, also den bei Anregung der gesamten BL-Abstrahlfläche ausgeleuchteten Bereich, erfasst. Taucht in diesem Bereich dann beispielsweise Gegenverkehr oder ein vorausfahrendes Fahrzeug auf, wird dies von der Steuereinheit ausgewertet und die Anregung des entsprechenden Bereichs der BL-Abstrahlfläche weggeschaltet.

Die Erfindung betrifft auch die Verwendung einer vorliegend beschriebenen Beleuchtungsvorrichtung für einen Kfz-Scheinwerfer. Weiterhin betrifft die Erfindung die Verwendung einer vorliegend beschriebenen Beleuchtungsvorrichtung bzw. eines entsprechenden Kfz-Scheinwerfers, wobei durch Anregung der unterschiedlichen Stellen des Leuchtstoffelements wahlweise unterschiedliche Raumrichtungen mit den Beleuchtungslicht-Strahlenbündeln ausgeleuchtet werden. Zum Kfz-Scheinwerfer alternative Anwendungsgebiete können beispielsweise im Bereich der Bühnen- oder Operationsfeldbeleuchtung liegen, die Beleuchtungsvorrichtung kann also auch Teil eines Bühnen-Scheinwerfers oder einer OP-Leuchte sein.

Generell wird vorzugsweise nicht die gesamte Pumpstrahlung konvertiert (Vollkonversion), sondern wird nur ein Teil konvertiert und dann eine Mischung aus Pumpstrahlung (Pumplicht) und Konversionslicht genutzt (Teilkonversion). Generell ist das Nutzlicht vorzugsweise Weißlicht; im Falle der Teilkonversion kann sich das Weißlicht dann beispielsweise aus blauem Pumplicht und dem Konversionslicht ergeben, wozu gelbes Konversionslicht (und dementsprechend ein gelber Leuchtstoff) bevorzugt ist. Als gelber Leuchtstoff kann beispielsweise YAG:Ce vorgesehen sein.

### Kurze Beschreibung der Figuren

Im Folgenden wird die Erfindung anhand von Ausführungsbeispielen näher erläutert, wobei die einzelnen Merkmale im Geltungsbereich der nebengeordneten Ansprüche auch in anderer Kombination erfindungswesentlich sein können; weiterhin wird nicht im Einzelnen zwischen den Anspruchskategorien unterschieden.

Im Einzelnen zeigt:
- Fig. 1: den Strahlengang von Beleuchtungslicht-Strahlenbündeln in einer Optik einer erfindungsgemäßen Beleuchtungsvorrichtung;
- Fig. 2: die Einkopplung der Pumpstrahlung in die Optik gemäß Fig. 1;
- Fig. 3: eine erfindungsgemäße Beleuchtungsvorrichtung mit drei Pumpstrahlungsquellen;
- Fig. 4: eine erfindungsgemäße Beleuchtungsvorrichtung mit zwei Pumpstrahlungsquellen, denen jeweils ein eigener Auslenkspiegel zugeordnet ist.

### Bevorzugte Ausführung der Erfindung

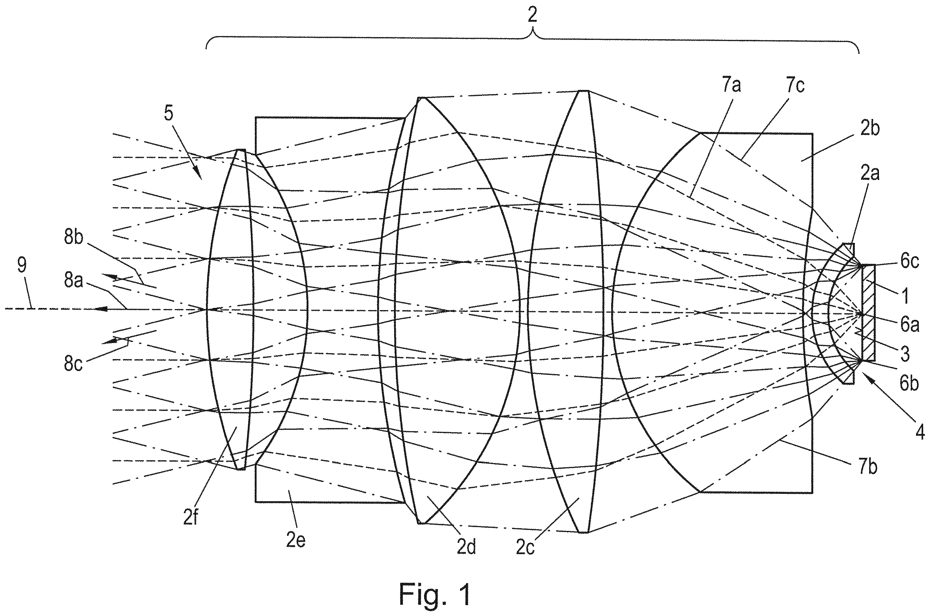

Fig. 1 zeigt einen Teil einer erfindungsgemäßen Beleuchtungsvorrichtung, nämlich ein Leuchtstoffelement 1 mit einer zugeordneten Optik 2. Die Optik 2 ist aus sechs sphärischen Linsen aufgebaut, mit denen das an einer Beleuchtungslicht-Abstrahlfläche 3 des Leuchtstoffelements 1 abgegebene Beleuchtungslicht aufgesammelt und einer Beleuchtungsanwendung zugeführt wird, nämlich zur Ausleuchtung einer Straße mittels eines Kfz-Scheinwerfers genutzt wird.

Das Beleuchtungslicht tritt an einer Leuchtstoffseite 4 in die Optik 2 ein, durchsetzt diese und tritt an einer entgegengesetzten Beleuchtungsseite 5 der Optik wieder aus. Bezogen auf die Richtung des Beleuchtungslichts ist die Optik 2 aus einem ersten 2a und einem zweiten Meniskus 2b, zwei asymmetrischen Bikonvexlinsen 2c,d, einer asymmetrischen Bikonkavlinse 2e und einer weiteren asymmetrischen Bikonvexlinse 2f aufgebaut.

Die Anordnung ist einseitig telezentrisch, die Optik 2 kollimiert von unterschiedlichen Stellen 6a,b,c der BL-Abstrahlfläche 3 ausgehende Beleuchtungslicht-Strahlenbündel 7a,b,c jeweils für sich. Die Ortsverteilung auf der Beleuchtungslicht-Abstrahlfläche 3 wird von der Optik 2 in eine Winkelverteilung umgesetzt, die von den unterschiedlichen Stellen 6a,b,c der BL-Abstrahlfläche 3 stammenden BL-Strahlenbündel haben der Optik 2 nachgelagert also jeweils eine andere Raumrichtung 8a,b,c. Dabei ist jedes der BL-Strahlenbündel der Optik 2 nachgelagert dann für sich kollimiert.

Aufgrund der Korrelation der Ortsverteilung auf der BL-Abstrahlfläche 3 mit der Winkelverteilung beleuchtungsseitig kann durch eine unterschiedliche Anregung der Stellen 6a,b,c der BL-Abstrahlfläche 3 eine unterschiedliche Lichtverteilung beleuchtungsseitig erreicht werden. Vorliegend ist ein die optische Achse 9 der Optik 2 beinhaltender Schnitt gezeigt und sind für diesen Schnitt nur drei BL-Strahlenbündel 7 exemplarisch dargestellt. Es kann aber von jeder Stelle der BL-Abstrahlfläche 3 ein entsprechendes Strahlenbündel ausgehen bzw. können eben dann in Abhängigkeit von der gewünschten Lichtverteilung beleuchtungsseitig die zugehörigen Bereiche der BL-Abstrahlfläche 3 bewusst nicht angeregt werden.

Fig. 2 illustriert nun eine entsprechende Beleuchtungsvorrichtung 21 im Gesamten, also das Leuchtstoffelement 1 mit der Optik 2 und einer Pumpstrahlungseinheit zur Anregung des Leuchtstoffelements 1. Die Pumpstrahlungseinheit weist eine Pumpstrahlungsquelle 22 auf, nämlich eine Laserdiode. Ein davon emittiertes Primärstrahlenbündel 23, vorliegend blaues Laser-Licht, wird mit einer Kollimationslinse 24 kollimiert und fällt so auf einen Mikroscanner 25, nämlich einen opto-elektro-mechanischen Mikrospiegelaktor. Dieser ist um zwei Achsen verkippbar, um eine zur Zeichenebene senkrechte Achse (welche für den vorliegenden Schnitt relevant ist) und um eine in der Zeichenebene liegende Achse.

Das Primärstrahlenbündel 23 fällt auf den Mikroscanner 25 und wird in Abhängigkeit von der Spiegelstellung als ein jeweiliges Pumpstrahlenbündel 26 umgelenkt. In der Figur ist die Umlenkung für drei Pumpstrahlenbündel 26a,b,c exemplarisch gezeigt, wobei diese Pumpstrahlenbündel 26a,b,c nicht simultan, sondern sequentiell vorliegen. Über nachstehend weiter im Detail beschriebene Elemente der Pumpstrahlungseinheit werden die Pumpstrahlenbündel 26a,b,c dann zu dem Leuchtstoffelement 1 geführt, und zwar über die Optik 2.

Zur Anregung einer bestimmten Stelle 6a,b,c der BL-Abstrahlfläche 3 wird also ein jeweiliges Pumpstrahlenbündel 26a,b,c in einer jeweiligen Pumpstrahlungs-Raumrichtung 27a,b,c auf die Beleuchtungsseite der Optik 2 gelenkt, welche Pumpstrahlungs-Raumrichtung 27a,b,c der jeweiligen Raumrichtung 8a,b,c des von der zugehörigen Stelle 6a,b,c der BL-Abstrahlfläche 3 abgegebenen BL-Strahlenbündels 7a,b,c genau entgegengesetzt liegt.

Indem also ein jeweiliges Pumpstrahlenbündel 26a,b,c in einer jeweiligen Raumrichtung 27a,b,c auf die Beleuchtungsseite 5 der Optik 2 fällt, wird eine jeweilige Stelle 6a,b,c der BL-Abstrahlfläche 3 angeregt; das auf die Anregung hin an der jeweiligen Stelle 6a,b,c der BL-Abstrahlfläche 3 abgegebene BL-Strahlenbündel 7a,b,c wird von der Optik 2 für sich kollimiert und beleuchtungsseitig in eine zur Raumrichtung 27a,b,c des entsprechenden Pumpstrahlenbündels 26a,b,c genau entgegengesetzte Raumrichtung 8a,b,c abgegeben. Indem also aus einer bestimmten Raumrichtung 27a,b,c angeregt wird, erfolgt die Abgabe des Konversionslichts in die genau entgegengesetzte Raumrichtung 8a,b,c.

Durch die in der Figur veranschaulichte Verkippung des Mikroscanners 25 um die zur Zeichenebene senkrechte Achse und die (nicht dargestellte) Verkippung um die in der Zeichenebene liegende Achse kann die gesamte BL-Abstrahlfläche 3 abgerastert werden, also bei dauerhaft eingeschalteter Pumpstrahlungsquelle 22 im Mittel die gesamte BL-Abstrahlfläche 3 angeregt werden. Wird nun mit einer Kamera beispielsweise ein entgegenkommendes oder vorausfahrendes Fahrzeug im Beleuchtungsbereich detektiert, wird die Abgabe des Konversionslichts in die entsprechenden Raumrichtungen 8a,b,c abgeschaltet. Dazu wird also in den entgegengesetzten Raumrichtungen 27a,b,c nicht mehr angeregt, wird also die Pumpstrahlungsquelle 22 bei entsprechenden Stellungen des Mikroscanners 25 abgeschaltet.

Neben dem Mikroscanner 25 umfasst die Pumpstrahlungseinheit ferner einen Einkoppelspiegel 30, der als orts- und positionsfestes Teil im Strahlengang der BL-Strahlenbündel 7 angeordnet ist. Da der Strahlquerschnitt des Primärstrahlenbündels 23 und damit der Pumpstrahlenbündel 26 gering ist, hat auch der Einkoppelspiegel 30 eine im Vergleich zum Querschnitt der BL-Strahlenbündel 7 kleine Fläche, schattet er also nur wenig Beleuchtungslicht ab. Auch deshalb ist der Einkoppelspiegel 30 als passives Bauelement ausgeführt, das also orts- und positionsfest angeordnet ist, was eine entsprechend einfache und damit wenig abschattende Halterung (nicht dargestellt) erlaubt.

Zwischen dem Auslenkspiegel 25 und dem Einkoppelspiegel 30 ist ein Relay-Linsensystem 31 mit einer Eingangslinse 31a und einer Ausgangslinse 31b vorgesehen. Eingangslinse 31a und Ausgangslinse 31b haben dieselbe Brennweite; der Auslenkspiegel 25 ist im pumpstrahlungsquellenseitigen Brennpunkt der Eingangslinse 31 angeordnet, der Einkoppelspiegel 30 im leuchtstoffseitigen Brennpunkt der Ausgangslinse 31b; die Eingangslinse 31a und die Ausgangslinse 31b sind um ihre zweifache Brennweite zueinander beabstandet.

Jedes Pumpstrahlenbündel 26 für sich wird von der Eingangslinse 31a gebündelt und dann von der Ausgangslinse 31b wieder kollimiert. Die Gesamtheit der Pumpstrahlenbündel 26 ist der Eingangslinse 31a vorgelagert relativ zueinander divergent, wird von der Eingangslinse 31a kollimiert und fällt dann von der Ausgangslinse 31b gebündelt auf den Einkoppelspiegel 30.

Fig. 3 zeigt eine weitere erfindungsgemäße Beleuchtungsvorrichtung 21, wobei das Leuchtstoffelement 1 und die Optik 2 zu den Elementen der Beleuchtungsvorrichtung 21 gemäß Fig. 2 baugleich sind. Im Falle der Beleuchtungsvorrichtung 21 gemäß Fig. 3 sind jedoch drei Pumpstrahlungsquellen 22a,b,c vorgesehen, die jeweils ein Primärstrahlenbündel 23a,b,c emittieren. Die Primärstrahlenbündel 23a,b,c werden dann über den gemeinsamen Mikroscanner 25 geführt, wobei jedes der Primärstrahlenbündel 23a,b,c entsprechend der vorstehenden Beschreibung aufgefächert wird. Die Zuordnung der Buchstaben in den Bezugszeichen der Pumpstrahlenbündel 26a,b,c ist nun abweichend von Fig. 2 nicht mehr mit den BL-Strahlenbündeln 7a,b,c korreliert, sondern mit den Primärstrahlenbündeln 23a,b,c. Die BL-Abstrahlfläche 3 wird nun nicht mehr mit einem einzigen Primärstrahlenbündel 23, das entsprechend im Mittel über die gesamte BL-Abstrahlfläche 3 geführt werden muss, angeregt, sondern eben mit drei Primärstrahlenbündeln 23a,b,c.

Dementsprechend ist die BL-Abstrahlfläche 3 in Teilbereiche untergliedert, wovon ein jeder mit einem der Primärstrahlenbündel 23a,b,c angeregt wird (und die teils überlappen). Letztlich ergibt sich aber dieselbe Funktionalität, werden also in Abhängigkeit von mit einer Kamera erfassten Bildinformationen bestimmte Bereiche nicht angeregt, was dann durch Ausschalten einer oder mehrerer der Pumpstrahlungsquellen 22a,b,c erreicht wird.

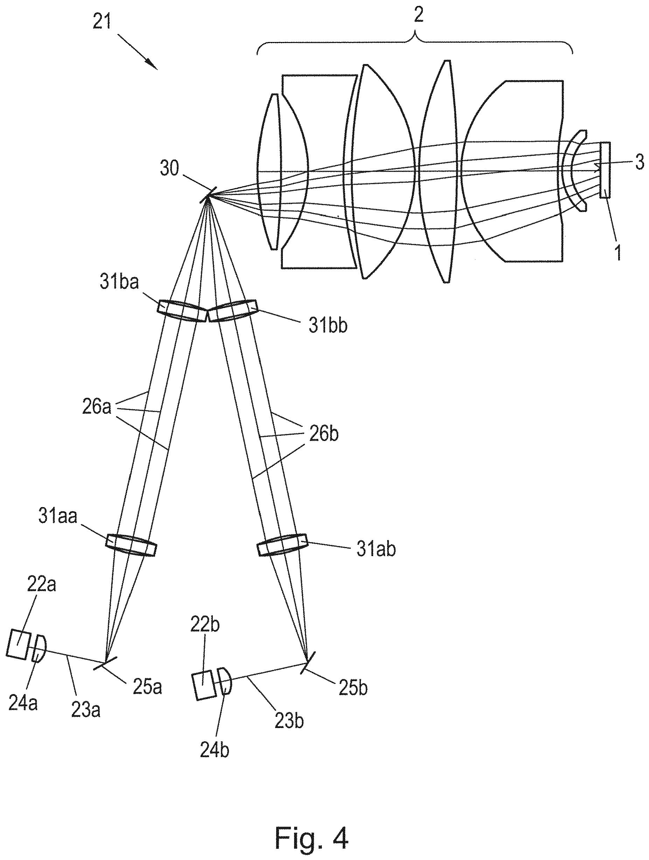

Auch die Beleuchtungsvorrichtung 21 gemäß Fig. 4 entspricht hinsichtlich Leuchtstoffelement 1 und Optik 2 den bisher beschriebenen Ausführungsformen. Weiterhin ist auch die Beleuchtungsvorrichtung 21 gemäß Fig. 4 mit zwei Pumpstrahlungsquellen 22a,b versehen, die sich in diesem Fall jedoch lediglich den Einkoppelspiegel 30 teilen. Davon abgesehen hat jede Pumpstrahlungseinheit ihr eigenes Relay-Linsensystem 31 und einen eigenen Auslenkspiegel 25 (hinsichtlich der Funktion dieser Elemente im Einzelnen wird auf die vorstehende Beschreibung verwiesen).

Das von einer jeweiligen Pumpstrahlungsquelle 22a,b ausgehende, jeweilige Primärstrahlenbündel 23a,b wird vom jeweiligen Auslenkspiegel 25a,b aufgefächert (im zeitlichen Verlauf) und über ein nachgelagertes, jeweiliges Relay-Linsensystem 31aa,ba,ab,bb geführt. Den dazu nachgelagerten Einkoppelspiegel 30 teilen sich die beiden Pumpstrahlungseinheiten dann, was auch hinsichtlich einer Minimierung der Abschattung vorteilhaft ist. Letztlich regt jede Pumpstrahlungsquelle 22a,b wiederum nur einen Teilbereich der BL-Abstrahlfläche 3 an, vgl. die Beschreibung zu Fig. 3.

## Patentansprüche

1. Beleuchtungsvorrichtung (21) zur variablen Beleuchtung in unterschiedlichen Raumrichtungen (8) mit einer Pumpstrahlungseinheit (22,25,30,31), welche eine Pumpstrahlungsquelle (22) zur Emission von Pumpstrahlung aufweist,
einem Leuchtstoffelement (1) zur zumindest teilweisen Konversion der Pumpstrahlung in Beleuchtungslicht, welches auf eine Anregung mit der Pumpstrahlung hin an einer Beleuchtungslicht-Abstrahlfläche (3) des Leuchtstoffelements (1) emittiert wird,
einer Optik (2), die dem Leuchtstoffelement (1) zugeordnet ist und Beleuchtungslicht-Strahlenbündel (7), die von unterschiedlichen Stellen (6) der Beleuchtungslicht-Abstrahlfläche (3) ausgehen und die Optik (2) auf einer Leuchtstoffseite (4) treffen, jeweils in eine andere Raumrichtung (8) der Ausbreitung auf einer der Leuchtstoffseite (4) entgegengesetzten Beleuchtungsseite (5) lenkt, also eine Ortsverteilung auf der Beleuchtungslicht-Abstrahlfläche (3) in eine beleuchtungsseitige Winkelverteilung umsetzt,
wobei die Pumpstrahlungseinheit (22,25,30,31) dazu ausgelegt ist, in unterschiedliche Raumrichtungen (27) einstellbar jeweils ein Pumpstrahlenbündel (26) abzugeben,
welche Pumpstrahlenbündel (26) beleuchtungsseitig eingekoppelt werden, nämlich durch die Optik (2) auf die Beleuchtungslicht-Abstrahlfläche (3) des Leuchtstoffelements (1) geführt werden, sodass die Optik (2) die beleuchtungsseitige Winkelverteilung in eine Ortsverteilung auf der Beleuchtungslicht-Abstrahlfläche (3) umsetzt, also die in unterschiedliche Raumrichtungen (27) abgegebenen Pumpstrahlenbündel (26) auf unterschiedliche Stellen (6) der Beleuchtungslicht-Abstrahlfläche (3) lenkt, womit einstellbar unterschiedliche Stellen (6) des Leuchtstoffelements (1) angeregt werden können,
wobei die Pumpstrahlungseinheit (22,25,30,31) einen Einkoppelspiegel (30), über welchen die Pumpstrahlenbündel (26) eingekoppelt werden und der zu diesem Zweck in einem Strahlengang der Beleuchtungslicht-Strahlenbündel (7) angeordnet ist, **dadurch gekennzeichnet, dass** die Pumpstrahlungseinheit einen Auslenkspiegel (25) aufweist, auf welchen ein von der Pumpstrahlungsquelle (22) emittiertes Primärstrahlenbündel (23) fällt und davon in Abhängigkeit von einer Spiegelstellung als eines der Pumpstrahlenbündel (26) umgelenkt wird,
wobei der Auslenkspiegel (25) außerhalb des Strahlengangs der Beleuchtungslicht-Strahlenbündel (7) angeordnet ist und der Einkoppelspiegel (30) dem Auslenkspiegel (25) nachgelagert als orts- und orientierungsfestes Teil in dem Strahlengang der Beleuchtungslicht-Strahlenbündel (7) angeordnet ist, und dass die Pumpstrahlungseinheit (22,25,30,31) ein Relay-Linsensystem (31) aufweist, das zwischen dem Auslenkspiegel (25) und dem Einkoppelspiegel (30) angeordnet ist.

2. Beleuchtungsvorrichtung (21) nach Anspruch 1, bei welcher die Anordnung von Optik (2) und Beleuchtungslicht-Abstrahlfläche (3) einseitig telezentrisch ist und die Optik (2) die von den unterschiedlichen Stellen (6) der Beleuchtungslicht-Abstrahlfläche (3) ausgehenden Beleuchtungslicht-Strahlenbündel (7) jeweils für sich kollimiert, wobei auch die Pumpstrahlenbündel (23) beleuchtungsseitig jeweils für sich kollimiert auf die Optik (2) treffen.

3. Beleuchtungsvorrichtung (21) nach Anspruch 1 oder 2, bei welcher die Optik (2) ein ausschließlich refraktives Linsensystem ist, das vorzugsweise aus einer Mehrzahl sphärischer Linsen (2a,b,c,d,e,f) besteht.

4. Beleuchtungsvorrichtung (21) nach Anspruch 1, bei welcher das Relay-Linsensystem (31) eine Ausgangslinse (31b) aufweist, wobei der Einkoppelspiegel (30) der Ausgangslinse (31b) nachgelagert in deren Brennpunkt angeordnet ist.

5. Beleuchtungsvorrichtung (21) nach Anspruch 1 oder 4, bei welcher das Relay-Linsensystem (31) eine Eingangslinse (31a) aufweist, wobei der Auslenkspiegel (25) der Eingangslinse (31a) vorgelagert in deren Brennpunkt angeordnet ist.

6. Beleuchtungsvorrichtung (21) nach einem der Ansprüche 1 bis 5, bei welcher als Auslenkspiegel ein in zumindest einer Achse verkippbarer Mikroscanner vorgesehen ist.

7. Beleuchtungsvorrichtung (21) nach Anspruch 1, welche mehrere Pumpstrahlungseinheiten (22,25,30,31) aufweist, die sich zumindest den Einkoppelspiegel (30) als gemeinsames Element teilen.

8. Kraftfahrzeug-Scheinwerfer mit einer Beleuchtungsvorrichtung (21) nach einem der vorstehenden Ansprüche.

9. Kraftfahrzeug-Scheinwerfer nach Anspruch 8 mit einer Erfassungseinheit, die dazu ausgelegt ist, einen beleuchtungsseitig mit den Beleuchtungslicht-Strahlenbündeln (7) zugänglichen Bereich zu erfassen.

10. Verwendung einer Beleuchtungsvorrichtung (21) nach einem der Ansprüche 1 bis 7 für einen Kraftfahrzeug-Scheinwerfer nach Anspruch 8 oder 9.

11. Verwendung einer Beleuchtungsvorrichtung (21) nach einem der Ansprüche 1 bis 7 oder eines Kraftfahrzeug-Scheinwerfers nach Anspruch 8 oder 9, bei welcher durch die Anregung der unterschiedlichen Stellen (6) der Beleuchtungslicht-Abstrahlfläche (3) wahlweise unterschiedliche Raumrichtungen (8) mit den Beleuchtungslicht-Strahlenbündeln (7) ausgeleuchtet werden.

## Claims

1. Illumination device (21) for variable illumination in different spacial directions (8) having
a pump radiation unit (22, 25, 30, 31), which has a pump radiation source (22) for emitting pump radiation,
a luminescent element (1) for at least partial conversion of the pump radiation into illumination light, which is emitted in response to excitation with the pump radiation on an illumination light emission surface (3) of the luminescent element (1),
optics (2) which are assigned to the luminescent element (1) and respectively direct illumination light ray bundles (7), which come from different positions (6) of the illumination light emission surface (3) and strike the optics (2) on a luminescent material side (4), into a different spatial direction (8) of the propagation on an illumination side (5) opposite to the luminescent material side (4), i.e. they convert a position distribution on the illumination light emission surface (3) into an angular distribution on the illumination side,
wherein the pump radiation unit (22, 25, 30, 31) is configured to respectively emit a pump ray bundle (26) adjustably in different spatial directions (27), which pump ray bundles (26) are coupled in on the illumination side, i.e. are guided by the optics (2) onto the illumination light emission surface (3) of the luminescent element (1), so that the optics (2) convert the angular distribution on the illumination side into a position distribution on the illumination light emission surface (3), i.e. they direct the pump ray bundles (26) emitted in different spatial directions (27) onto different positions (6) of the illumination light emission surface (3), so that different positions (6) of the luminescent element (1) can be adjustably excited,
wherein the pump radiation unit (22, 25, 30, 31) has an input coupling mirror (30), via which the pump ray bundles (26) are coupled in and which is to this end arranged in a beam path of the illumination light ray bundles (7), **characterized in that** the pump radiation unit has a deviating mirror (25), which a primary ray bundle (23) emitted by the pump radiation source (22) strikes and is deviated therefrom as a function of a mirror setting as one of the pump ray bundles (26), wherein the deviating mirror (25) is arranged outside the beam path of the illumination light ray bundles (7), and the input coupling mirror (30) is arranged after the deviating mirror (25) as a part fixed in position and orientation in the beam path of the illumination light ray bundles (7),
and **in that** the pump radiation unit (22, 25, 30, 31) has a relay lens system (31), which is arranged between the deviating mirror (25) and the input coupling mirror (30).

2. Illumination device (21) according to Claim 1, wherein the arrangement of the optics (2) and the illumination light emission surface (3) is telecentric on one side, and the optics (2) respectively collimate per se the illumination light ray bundles (7) coming from the different positions (6) of the illumination light emission surface (3), the pump ray bundles (26) respectively also striking the optics (2) on the illumination side while being collimated per se.

3. Illumination device (21) according to Claim 1 or 2, wherein the optics (2) are an exclusively refractive lens system, which preferably consists of a multiplicity of spherical lenses (2a,b,c,d,e,f).

4. Illumination device (21) according to Claim 1, wherein the relay lens system (31) has an output lens (31b), the input coupling mirror (30) being arranged after the output lens (31b) at the focal point of the latter.

5. Illumination device (21) according to Claim 1 or 4, wherein the relay lens system (31) has an input lens (31a), the deviating mirror (25) being arranged before the input lens (31a) at the focal point of the latter.

6. Illumination device (21) according to one of Claims 1 to 5, wherein a microscanner, which can be tilted in at least one axis, is provided as the deviating mirror.

7. Illumination device (21) according to Claim 1, which has a plurality of pump radiation units (22, 25, 30, 31) which share at least the input coupling mirror (30) as a common element.

8. Motor vehicle headlamp having an illumination device (21) according to one of the preceding claims.

9. Motor vehicle headlamp according to Claim 8, having a detection unit which is configured to detect a region that is accessible on the illumination side to the illumination light ray bundles (7).

10. Use of an illumination device (21) according to one of Claims 1 to 7 for a motor vehicle headlamp according to Claim 8 or 9.

11. Use of an illumination device (21) according to one of Claims 1 to 7 or of a motor vehicle headlamp according to Claim 8 or 9, wherein different spatial directions (8) are illuminated selectively with the illumination light ray bundles (7) by excitation of the different positions (6) of the illumination light emission surface (3).

## Revendications

1. Dispositif d'éclairage (21) pour éclairage variable dans différentes directions spatiales (8) avec :
- une unité de rayonnement de pompage (22, 25, 30, 31), qui comporte une source de rayonnement de pompage (22) pour l'émission d'un rayonnement de pompage ;
- un élément luminescent (1) pour la conversion au moins partielle du rayonnement de pompage en lumière d'éclairage qui, sur excitation par le rayonnement de pompage, est émise au niveau d'une surface de rayonnement de la lumière d'éclairage (3) de l'élément luminescent (1) ;
- une optique (2) qui est associée à l'élément luminescent (1) et qui dirige des rayons de lumière d'éclairage (7), qui partent de différents points (6) de la surface de rayonnement de la lumière d'éclairage (3) et frappent l'optique (2) sur un côté luminescent (4), respectivement dans une autre direction spatiale (8) de la propagation sur un côté d'éclairage (5) opposé au côté luminescent (4), c'est-à-dire transforme une distribution locale sur la surface de rayonnement de la lumière d'éclairage (3) en une distribution angulaire côté éclairage,
l'unité de rayonnement de pompage (22, 25, 30, 31) étant conçue pour émettre de manière réglable, dans différentes directions spatiales (27), respectivement un rayon de pompage (26) qui est injecté côté éclairage, à savoir dirigé par l'optique (2) sur la surface de rayonnement de la lumière d'éclairage (3) de l'élément luminescent (1), de sorte que l'optique (2) transforme la distribution angulaire côté éclairage en une distribution locale sur la surface de rayonnement de la lumière d'éclairage (3), c'est-à-dire dirige les rayons de pompage (26) émis dans différentes directions spatiales (27) sur différents points (6) de la surface de rayonnement de la lumière d'éclairage (3), de sorte que différents points (6) de l'élément luminescent (1) peuvent être excités de manière réglable,
l'unité de rayonnement de pompage (22, 25, 30, 31) comportant un miroir d'entrée (30) via lequel les rayons de pompage (26) sont injectés et qui, à cet effet, est agencé dans un chemin optique des rayons de lumière d'éclairage (7),
**caractérisé en ce que** l'unité de rayonnement de pompage comporte un miroir de sortie (25) sur lequel tombe un rayon primaire (23) émis par la source de rayonnement de pompage (22) et qui en est dévié en fonction d'une position du miroir en tant que l'un des rayons de pompage (26),
le miroir de sortie (25) étant agencé en dehors du chemin optique des rayons de lumière d'éclairage (7) et le miroir d'entrée (30) étant agencé en aval du miroir de sortie (25) en tant que partie stationnaire et orienté à demeure dans le chemin optique des rayons de lumière d'éclairage (7), et **en ce que** l'unité de rayonnement de pompage (22, 25, 30, 31) comporte un système de lentilles de relais (31) qui est agencé entre le miroir de sortie (25) et le miroir d'entrée (30).

2. Dispositif d'éclairage (21) selon la revendication 1, dans lequel l'ensemble composé de l'optique (2) et de la surface de rayonnement de la lumière d'éclairage (3) est télécentrique d'un côté et l'optique (2) collimate chacun pour soi les rayons de lumière d'éclairage (7) partant des différents points (6) de la surface de rayonnement de la lumière d'éclairage (3), les rayons de pompage (23) côté éclairage, collimatés chacun pour soi, frappant aussi l'optique (2).

3. Dispositif d'éclairage (21) selon la revendication 1 ou 2, dans lequel l'optique (2) est un système de lentilles uniquement réfractif qui se compose préférentiellement d'une pluralité de lentilles sphériques (2a, b, c, d, e, f) .

4. Dispositif d'éclairage (21) selon la revendication 1, dans lequel le système de lentilles de relais (31) comporte une lentille de sortie (31b), le miroir d'entrée (30) étant agencé en aval de la lentille de sortie (31b) dans le foyer de celle-ci.

5. Dispositif d'éclairage (21) selon la revendication 1 ou 4, dans lequel le système de lentilles de relais (31) comporte une lentille d'entrée (31a), le miroir de sortie (25) étant agencé en amont de la lentille d'entrée (31a) dans le foyer de celle-ci.

6. Dispositif d'éclairage (21) selon l'une des revendications 1 à 5, dans lequel est prévu, en tant que miroir de sortie, un microscanner pouvant basculer selon au moins un axe.

7. Dispositif d'éclairage (21) selon la revendication 1, lequel comporte plusieurs unités de rayonnement de pompage (22, 25, 30, 31) qui se partagent au moins le miroir d'entrée (30) en tant qu'élément commun.

8. Phare de véhicule automobile comportant un dispositif d'éclairage (21) selon l'une des revendications précédentes.

9. Phare de véhicule automobile selon la revendication 8 comportant une unité de détection qui est conçue pour détecter une zone pouvant être accédée par les rayons de lumière d'éclairage (7) côté éclairage.

10. Utilisation d'un dispositif d'éclairage (21) selon l'une des revendications 1 à 7 pour un phare de véhicule automobile selon la revendication 8 ou 9.

11. Utilisation d'un dispositif d'éclairage (21) selon l'une des revendications 1 à 7 ou d'un phare de véhicule automobile selon la revendication 8 ou 9, dans laquelle différentes directions spatiales (8) sont éclairées sélectivement par les rayons de lumière d'éclairage (7) par excitation des différents points (6) de la surface de rayonnement de la lumière d'éclairage (3).
